(19) Europäisches Patentamt
European Patent Office
Office européen des brevets

(11) Veröffentlichungsnummer : **0 142 463 B1**

(12) # EUROPÄISCHE PATENTSCHRIFT

(45) Veröffentlichungstag der Patentschrift : **20.09.89**

(51) Int. Cl.⁴ : **C 08 J 5/24**, C 08 G 59/68, C 08 G 59/50// C08L63/00

(21) Anmeldenummer : **84810409.7**

(22) Anmeldetag : **20.08.84**

(54) **Verfahren zur Herstellung von Prepregs und die damit erhältlichen verstärkten Verbundstoffe.**

(30) Priorität : **24.08.83 CH 4615/83**

(43) Veröffentlichungstag der Anmeldung : **22.05.85 Patentblatt 85/21**

(45) Bekanntmachung des Hinweises auf die Patenterteilung : **20.09.89 Patentblatt 89/38**

(84) Benannte Vertragsstaaten : **CH DE FR GB IT LI**

(56) Entgegenhaltungen :
**GB–A– 1 570 992**
**GB–A– 2 029 433**
**US–A– 4 410 680**
**CHEMICAL ABSTRACTS, Band 86, Nr. 2, 10. Januar 1977, Seite 42, Nr. 6455z, Columbus, Ohio, US; & JP - A - 76 101 100**

(73) Patentinhaber : **CIBA-GEIGY AG**
**Klybeckstrasse 141**
**CH-4002 Basel (CH)**

(72) Erfinder : **Forgò, Imre, Dr.**
**Am Stausee 27/16**
**CH-4127 Birsfelden (CH)**
Erfinder : **Manso, Elvio**
**Am Stausee 23/4**
**CH-4127 Birsfelden (CH)**
Erfinder : **Gruber, Urs, Dr.**
**Hangstrasse 18**
**CH-4144 Arlesheim (CH)**
Erfinder : **Huwyler, René, Dr.**
**Bärenfelsweg 5**
**CH-4147 Aesch (CH)**

**EP 0 142 463 B1**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

**Beschreibung**

Die vorliegende Erfindung betrifft ein Verfahren zur Herstellung von Prepregs und die damit durch Heisshärten erhältlichen verstärkten Verbundstoffe.

Lagerstabile Prepregs zur Herstellung von faserverstärkten Verbundstoffen können beispielsweise dadurch hergestellt werden, dass man faserförmiges Verstärkungsmaterial mit einer eine Epoxidverbindung, eine photopolymerisierbare Verbindung, einen hitzeaktivierbaren Härter für das Epoxidharz und gegebenenfalls einen Photopolymerisationskatalysator enthaltenden Masse imprägniert und das imprägnierte Material so mit aktinischer Strahlung belichtet, dass sich die Masse durch Photopolymerisation der photopolymerisierbaren Verbindung verfestigt, während das Epoxidharz im wesentlichen in heisshärtbarem Zustand verbleibt. Als Härter für das Epoxidharz werden dabei relativ wenig aktive Verbindungen, sogenannte « latente » Härter, wie Polycarbonsäureanhydride, Dicyandiamid, Komplexe von bevorzugt tertiären Aminen mit $BF_3$ oder $BCl_3$, aromatische Polyamine oder Imidazole verwendet (vgl. z. B. deutsche Offenlegungsschriften 27 06 549 und 27 06 638). Die britische Patentschrift 1.386.122 beschreibt lichtempfindliche Beschichtungsmaterialien zur selektiven Herstellung dielektrischer Schichten, die mindestens ein mehrfunktionelles photopolymerisierbares Vinylmonomer, einen Photosensibilisator für die Photopolymerisation des Vinylmonomeren unter aktinischer Bestrahlung, ein teilweise ausgehärtetes vernetzbares Polymer, z. B. ein bis zur B-Stufe gehärtetes Epoxidharz, und einen hitzeaktivierbaren Härter für das teilweise ausgehärtete Polymer enthalten. Dabei können an sich bekannte Härter eingesetzt werden, wobei sich jedoch aromatische und aliphatische Aminhärter wegen störender Nebenreaktionen mit den bevorzugten Vinylmonomeren als ungeeignet erwiesen haben. Anhydride und Dicyandiamid werden als Härter bevorzugt.

Weiter sind aus der GB-A-2,029,433 Druckfarben bekannt, die ein Bindersystem aus photopolymerisierbaren, polyethylenisch ungesättigten Monomeren, in diesen Monomeren löslichen Epoxidharzen, einem Photoinitiator und einem « Kalt-Härter » für die Epoxidharze enthalten. Als « Kalt-Härter » werden solche Härter bezeichnet, die das Epoxidharz bei Raumtemperatur (15-25 °C) härten. Als Beispiele für solche Härter sind Amine wie z. B. Alkylendiamine oder aminosubstituierte Alkoxysilane oder Polyisocyanate genannt.

Jedoch sind diese Druckfarben nicht lagerstabil, so dass sie als Zweikomponenten-Systeme gelagert werden müssen, wobei das Epoxidharz und der « Kalt-Härter » getrennt sind und erst kurz vor der Verwendung zusammengebracht werden.

Für gewisse Anwendungen, insbesondere dort, wo Prepregs im Betrieb hergestellt und weiterverarbeitet werden, ist keine so lange Lagerfähigkeit erforderlich, wie sie normalerweise mit den oben genannten latenten Härtern, vor allem Dicyandiamid, erreichbar ist. Hingegen sind bei solchen Anwendungen kürzere Härtungszeiten bei tiefen Temperaturen, vorzugsweise bei Temperaturen unter 120 °C, erwünscht. Verkürzte Härtungszeiten bei tiefen Temperaturen können bei üblichen Epoxidharz/Härter-Systemen durch den Einsatz von schnellhärtenden reaktiven aliphatischen oder alicyclischen Aminen, unter Umständen sogar ohne Zusatz von Beschleunigern, erreicht werden. Dabei werden jedoch die Topfzeit und die Gebrauchsdauer solcher Harz/Härter-Systeme mit zunehmender Reaktivität der Aminhärter stark verkürzt. Diese Systeme eignen sich deshalb beispielsweise nicht für die Herstellung von Prepregs, weil sich das Harz/Härter-Gemisch schon bei Raumtemperatur innerhalb weniger Stunden verfestigt.

Aufgabe der Erfindung war somit die Bereitstellung eines Verfahrens, nach dem sich Prepregs unter Vermeidung der oben genannten Nachteile mit verkürzten Reaktionszeiten bei tiefen Temperaturen herstellen lassen.

Gegenstand der Erfindung ist dementsprechend ein neues Verfahren zur Herstellung von Prepregs, indem man ein Verstärkungsmaterial mit einer

a) ein Epoxidharz,

b) eine photopolymerisierbare Verbindung,

c) einen hitzeaktivierbaren Härter für das Epoxidharz a) und gegebenenfalls

d) einen Photopolymerisationskatalysator für die photopolymerisierbare Verbindung b) enthaltenden flüssigen lösungsmittelfreien Masse imprägniert und mit aktinischer Strahlung belichtet, bis sich die Masse durch Photopolymerisation der photopolymerisierbaren Verbindung zu einer im wesentlichen festen Schicht verfestigt, während das Epoxidharz weitgehend in heisshärtbarem Zustand verbleibt, wobei man als hitzeaktivierbaren Härter c) ein gegebenenfalls substituiertes aliphatisches, cycloaliphatisches oder araliphatisches Amin verwendet und die photopolymerisierbare Verbindung b) in einem solchen Verhältnis zu der thermisch härtbaren Komponente a) einsetzt, dass die Masse nach der Bestrahlung mit aktinischem Licht, d. h. der Prepreg, noch thermoplastisch verformbar ist.

Nach dem erfindungsgemässen Verfahren lassen sich klebrige bis grifftrockene Prepregs herstellen, die nur kurze Härtungszeiten bei relativ tiefen Temperaturen benötigen. Das dabei verwendete flüssige lösungsmittelfreie Harz/Härter-Gemisch weist eine überraschend lange Gebrauchsdauer und lange Topfzeiten auf. Dank der kurzen Härtungszeiten können auch die Takt- bzw. Formbelegungszeiten bei der Herstellung verschiedener Verbundkörper, wie z. B. Skis, Tennisschlägern, Autokarosserieteilen und Gehäusen, wesentlich herabgesetzt werden. Die erfindungsgemäss mittels aktinischer Strahlung vorreagierten Prepregs zeichnen sich beim Pressen in der beheizten Presse zudem durch einen sogenannten gebremsten Fluss auf, d. h. die Viskosität des Systems verringert sich bei der für die thermische Härtung erforderlichen Temperaturerhöhung nur relativ wenig. Dies hat den Vorteil, dass das Harz nicht oder nur geringfügig aus dem Verstärkungsmaterial ausläuft. Folglich ist die Gefahr des Auftretens von sogenannten Ausmagerungsstellen, d. h. Stellen ohne Harz, gering. Ferner werden dabei die Presswerkzeuge wie auch die Presse weniger verschmutzt. Dass nach dem erfindungsgemässen Verfahren auf den Einsatz von Lösungsmitteln verzichtet werden kann, stellt einen weiteren wesentlichen wirtschaftlichen und ökologischen Vorteil dar.

Gegenstand der Erfindung sind auch die nach dem erfindungsgemässen Verfahren hergestellten Prepregs sowie deren Verwendung zur Herstellung von verstärkten Verbundstoffen, indem man die Prepregs einer Heisshärtung unterwirft.

Das Verstärkungsmaterial kann z. B. in Form gewobener oder ungewobener Schichten, unidirektionaler oder geschnittener Stränge vorliegen und aus natürlichen oder synthetischen Fasern, besonders Glas-, Bor-, rostfreien Stahl-, Wolfram-, Siliciumcarbid-, Asbest-, Kohlenstoff- oder aromatischen Polyamidfasern, wie Poly-(m-phenylenisophthalamid)- oder Poly(p-phenylenterephthalimid)-fasern, bestehen. Glasfasern sind als Verstärkungsmaterial besonders bevorzugt.

Bei den erfindungsgemäss zu verwendenden gegebenenfalls substituierten aliphatischen, cycloaliphatischen oder araliphatischen (Poly)Aminen handelt es sich vorzugsweise um Verbindungen mit mindestens zwei Aminogruppen, wovon mindestens eine eine primäre oder sekundäre Aminogruppe ist. Als Substituenten an derartigen Aminen kommen z. B. CN-Gruppen, Alkyl- und Aminoalkylgruppen mit 1-12 und besonders 1-4 C-Atomen, besonders Methyl-, Aethyl, Aminomethyl-, 2-Aminoäthyl- und 3-Aminopropylgruppen, $C_{5-8}$-Cycloalkyl-, $C_{7-8}$-Aralkyl-, Phenyl-, $C_{1-4}$-Alkylphenyl-, $C_{1-4}$-Alkoxyphenyl-, Halogenphenyl- und Hydroxyphenylgruppen, wie Methylphenyl-, Aethylphenyl-, Isopropylphenyl-, Methoxyphenyl-, Aethopxyphenyl-, Chlorphenyl- und Dichlorphenylgruppen, $—(CH_2)_s—$ (s = 2-8), $C_{2-8}$-Alkyliden- und $C_{5-8}$-Cycloalkylidengruppen,. sowie 5- oder 6-gliedrige heterocyclische Reste, wie Furyl-, Tetrahydrofuryl-, Thienyl-, Piperidyl- und Piperazinylgruppen, in Betracht.

Aliphatische Amine können geradkettig oder verzweigt und gegebenenfalls substituiert sein. Beispiele geeigneter Amine sind :

1. Diprimäre Alkylendiamine mit mindestens zwei und bevorzugt 2-14 C-Atomen, die in der Kette durch NH- oder O-Atome unterbrochen sein können, wie Aethylendiamin, 1,2- oder 1,3-Propylendiamin, Tetramethylendiamin, Pentaäthylendiamin, Hexamethylendiamin, Octamethylendiamin ; Polyäthylendiamine der Formel $H_2N—CH_2CH_2(NH—CH_2CH_2)_b—NH_2$, worin b eine ganze Zahl von 1-6 bedeutet, wie Diäthylentriamin, Triäthylentetramin und Tetraäthylenpentamin ; Polyoxyäthylendiamine, Polyoxypropylendiamine, 3-(2-Aminoäthyl)-aminopropylamin, 1,2-Bis-(3-Aminopropylamino)äthan und N,N'-Bis-(3-aminpropyl)-1,4-diaminobutan.

2. Amine der Formeln I bis V

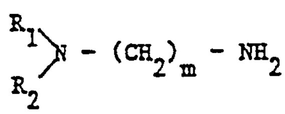
(I)

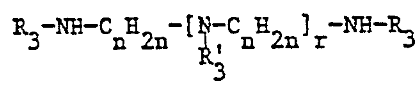
(II)

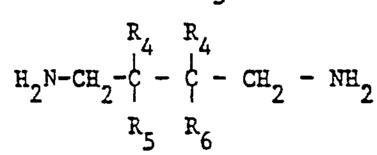
(III)

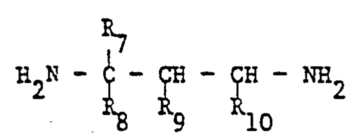
(IV)

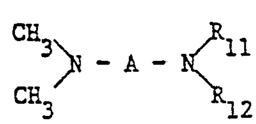
(V)

worin

m eine ganze Zahl von 2 bis 6, besonders 2 oder 3,

n eine ganze Zahl von 2-12, besonders 3 bis 6,

r Null, 1 oder 2,

$R_1$ Wasserstoff, $C_{1-4}$-Alkyl, besonders Methyl oder Aethyl,

$R_2$ $C_{1-4}$-Alkyl, besonders Methyl oder Aethyl, Cyclopentyl, oder Cyclohexyl,

die $R_3$ je Cyclopentyl, Cyclohexyl, Benzyl oder Phenyläthyl,

$R_3'$ dasselbe wie $R_3$ oder Wasserstoff,

$R_4$ die unabhängig voneinander Wasserstoff oder Methyl,

$R_5$ Phenyl, Chlorphenyl oder Isopropylphenyl,

$R_6$ Phenyl, Chlorphenyl oder Methoxyphenyl,

$R_7$ und $R_9$ unabhängig voneinander Wasserstoff oder $C_{1-4}$-Alkyl,

$R_8$ Phenyl oder einen 5- oder 6-gliedrigen heterocyclischen Rest und

$R_{10}$ Wasserstoff, $C_{1-4}$-Alkyl, Phenyl oder einen 5- oder 6-gliedrigen heterocyclischen Rest bedeuten oder

$R_7$ und $R_8$ und/oder $R_9$ und $R_{10}$ zusammen $-(CH_2)_q-$ mit q = 4 oder 5 darstellen,

$R_{11}$ $C_{1-12}$-Alkyl, besonders $C_{1-8}$-Alkyl und vor allem $C_{1-4}$-Alkyl, $C_{6-8}$-Cycloalkyl, $C_{7-8}$-Aralkyl, $-A_1-CN$ oder $-A_2-CH_2NH_2$ und

$R_{12}$ Wasserstoff oder $-A_2-CH_2NH_2$

und A, $A_1$ und $A_2$ unabhängig voneinander Aethylen, 1,2- oder 1,3-Propylen bedeuten. Dabei ist A bevorzugt 1,3-Propylen und $A_1$ und $A_2$ sind vorzugsweise Aethylen. Als 5- oder 6-gliedrige heterocyclische Rest $R_8$ und $R_{10}$ kommen vor allem Tetrahydrofuryl- oder Pyridylgruppen in Betracht.

3. Aliphatische Polyamino-amide, wie die unter den Handelsnamen Versamid® 115 und Versamid® 125 bekannten Produkte, oder ähnliche Reaktionsprodukte aus aliphatischen Aminen und Fettsäuren, besonders dimerisierten oder trimerisierten Fettsäuren.

4. Cycloaliphatische Amine, die im Ring auch Heteroatome, besonders N-Atome, aufweisen können, wie z. B. 1,2- oder 1,3-Diaminocyclopentan, 1,2-, 1,3- oder 1,4-Diaminocyclohexan, 3,3'-, 3,4'- oder 4,4'-Diaminodicyclohexylmethan, 4,4'-Diamino-3,3'-dimethyldicyclohexylmethan, Isophorondiamin, N-Aminoäthylpiperazin, N,N'-Bis(3-aminopropyl)piperazin, N-Aminomethylpiperidin, 1,3- und 1,4-(Aminomethyl-)cyclohexan und 3(4),8(9)-Bis-aminomethyl-tricyclo-[$5.2.1.0^{2,6}$]decan.

5. Als araliphatische Amine eignen sich z. B. 1,3- und 1,4-Xylylendiamin.

6. Addukte von Aminen der oben genannten Art, wie Aethylendiamin, Hexamethylendiamin, Diäthylentriamin, Triäthylentetramin, Tetraäthylenpentamin, 1,2- oder 1,3-Diaminocyclohexan oder Isophorondiamin, an Acrylnitril, Aethylenoxid, Propylenoxid oder Polyepoxide.

Es können auch Gemische verschiedener Amine eingesetzt werden. Die genannten Amine sind bekannt oder können nach an sich bekannten Verfahren hergestellt werden [vgl. z. B. US Patentschriften 4.182.832, 4.193.905 und 4.201.854].

Als Verbindungen der Formel I sind solche bevorzugt, worin m die Zahl 2 oder 3, $R_1$ Wasserstoff, Methyl oder Aethyl und $R_2$ Methyl, Aethyl oder Cyclohexyl bedeuten.

Unter den Verbindungen der Formel II werden diejenigen bevorzugt, worin die $R_3$ je Cyclohexyl oder Benzyl, $R_3'$ Wasserstoff, Cyclohexyl oder Benzyl, und die Gruppe $-C_nH_{2n}-$, $-(CH_2)_n-$ mit n = 3 bis 6 bedeuten und r die angegebene Bedeutung hat.

Als Verbindungen der Formel III werden 1,4-Diamino-2,3-diphenylbutan und 1,4-Diamino-2,3-dimethyl-2,3-diphenylbutan bevorzugt.

Unter den Verbindungen der Formel IV sind diejenigen bevorzugt, worin :

$R_7$ und $R_9$ Wasserstoff, $R_8$ Phenyl und $R_{10}$ Wasserstoff, Methyl, tert-Butyl, Phenyl, Tetrahydrofuryl oder Pyridyl bedeuten ;

$R_7$ Wasserstoff, $R_8$ und $R_{10}$ Phenyl und $R_9$ Methyl sind ;

$R_7$ Wasserstoff, $R_8$ Methyl oder Phenyl und $R_9$ und $R_{10}$ zusammen Tetramethylen bedeuten ;

$R_7$ und $R_8$ zusammen Pentamethylen und $R_9$ und $R_{10}$ zusammen Tetramethylen sind ;

$R_7$ Methyl, $R_8$ und $R_{10}$ Phenyl und $R_9$ Wasserstoff bedeuten.

Beispiele besonders geeigneter Verbindungen der Formel IV sind 1,3-Diamino-1,3-diphenylpropan, 1,3-Diamino-1-phenyl-3(2-tetrahydrofuryl)propan und 1,3-Diamino-1,3-diphenyl-2-methylpropan.

In Formel V stellt $R_{12}$ bevorzugt ein Wasserstoffatom dar und $R_{11}$ ist Aethyl, n-Propyl, Isopropyl, n-Butyl, Isobutyl, Cyclopentyl, Cyclohexyl, 2-Cyanoäthyl oder 3-Aminopropyl. Des weiteren sind Verbindungen der Formel V bevorzugt, worin $R_{11}$ 2-Cyanoäthyl oder 3-Aminopropyl und $R_{12}$ 3-Aminopropyl bedeuten. Besonders bevorzugt sind Verbindungen der Formel V, worin A Aethylen und vor allem 1,3-Propylen ist, $R_{12}$ Wasserstoff und $R_{11}$ 2-Cyanoäthyl oder 3-Aminopropyl bedeuten.

Einige Beispiele für Verbindungen der Formel V sind :

N,N-Dimethyl-N'-(2-cyanoäthyl)äthylendiamin,

N,N-Dimethyl-N'-(3-aminopropyl)äthylendiamin,

N,N-Dimethyl-N',N'-di-(3-aminopropyl)äthylendiamin,

N,N-Dimethyl-N'-(2-cyanoäthyl)-1,3-diaminopropan,
N,N-Dimethyl-N'-(3-aminopropyl)-1,3-diaminopropan,
N,N-Dimethyl-N',N'-di-(3-aminopropyl)-1,3-diaminopropan.

Besonders bevorzugt verwendet man als Amine Tetramethylendiamin, Hexamethylendiamin, Polyäthylendiamine $H_2N—CH_2CH_2—(NH—CH_2CH_2)_b—NH_2$ mit b = 1-6, besonders 1-4, 1,2-Diaminocyclohexan, 1,3- oder 1,4-Bis-(aminomethyl)-cyclohexan, 4,4'-Diaminodicyclohexylmethan, 1,3- und 1,4-Xylylendiamin, 1,3-Diamino-1,3-diphenylpropan, 1,3-Diamino-1-phenyl-3-(2-tetrahydrofuryl)propan, N-Aethylaminopiperazin, 3-Aminomethyl-3,5,5-trimethylcyclohexylamin (Isophorondiamin), N,N-Dimethyl-1,3-diaminopropan, N,N-Diäthyl-1,3-diaminopropan, N,N-Dimethyl-N'-(3-aminopropyl)-1,3-diaminopropan und N,N-Dimethyl-N'-(2-cyanoäthyl)-1,3-diaminopropan, oder Gemische davon.

Ganz besonders bevorzugt sind Isophorondiamin oder Gemische aus N,N-Dimethyl-N'-(3-aminopropyl)1,3-diaminopropan und N,N-Dimethyl-N'-(2-cyanoäthyl)1,3-diaminopropan.

Härter c), die nur primäre und/oder sekundäre Aminogruppen aufweisen, werden zweckmässig in einer Menge von 0,8 bis 1,2 Aminwasserstoff-Aequivalenten, besonders etwa 1 Aminwasserstoff-Aequivalent, pro Epoxidäquivalent verwendet. Weist der Amin-Härter c) auch tertiäre Aminogruppen auf, so kann die für die Härtung der Epoxidharze a) erforderliche Menge an Aminwasserstoff-Aequivalenten pro Epoxidäquivalent auf etwa 0,2, bevorzugt 0,25 bis 0,5, reduziert werden.

Als Epoxidharze a), photopolymerisierbare Verbindungen b) und gegebenenfalls Photopolymerisationskatalysatoren d) können an sich bekannte Verbindungen eingesetzt werden, wie sie z. B. in der deutschen Offenlegungsschrift 27 06 549 beschrieben sind.

Geeignete Epoxidharze, d. h. Stoffe mit mehr als einer Epoxidgruppe pro Durchschnittsmolekül, sind vorzugsweise solche, die an Kohlenstoff-, Sauerstoff-, Stickstoff- oder Schwefelatome gebundene Gruppen der Formel A

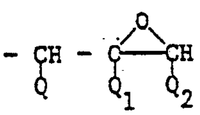
(A)

enthalten und frei von Acryloyl- oder Methacryloylgruppen sind, wobei Q und $Q_2$ je ein Wasserstoffatom und $Q_1$ ein Wasserstoffatom oder die Methylgruppe bedeuten oder Q und $Q_2$ zusammen $—CH_2CH_2—$ oder $—CH_2CH_2CH_2—$ und $Q_1$ ein Wasserstoffatom bedeuten.

Als Beispiele solcher Harze seien Polyglycidyl- und Poly(β-methylglycidyl)ester genannt, die durch Umsetzung einer zwei oder mehr Carboxylgruppen pro Molekül enthaltenden Verbindung mit Epichlorhydrin, Glycerindichlorhydrin oder β-Methylepichlorhydrin in alkalischem Medium erhalten werden. Solche Polyglycidylester können sich von aliphatischen, cycloaliphatischen oder aromatischen Polycarbonsäuren ableiten. Beispiele geeigneter Polycarbonsäuren sind Bernsteinsäure, Glutarsäure, Adipinsäure, Pimelinsäure, Korksäure, Azelainsäure, Sebacinsäure, dimerisierte oder trimerisierte Linolsäure, Tetrahydrophthalsäure, 4-Methyltetrahydrophthalsäure, Hexahydrophthalsäure, 4-Methylhexahydrophthalsäure, Phthalsäure, Iso- und Terephthalsäure.

Weitere Beispiele sind Polyglycidyl- und Poly(β-methylglycidyl)-äther, die durch Umsetzung einer mindestens zwei alkoholische und/oder phenolische Hydroxylgruppen pro Molekül enthaltenden Verbindung mit Epichlorhydrin oder mit Allylchlorid und anschliessende Epoxidierung mit Persäuren erhalten werden.

Geeignete Polyole sind z. B. Aethylenglykol, Diäthylenglykol, Poly(oxyäthylen)glykole, Propan-1,2-diol, Poly(oxypropylen)-glykole, Propan-1,3-diol, Butan-1,4-diol, Poly(oxytetramethylen)-glykole, Pentan-1,5-diol, Hexan-2,4,6-triol, Glycerin, 1,1,1-Trimethylolpropan, Pentaerythrit und Sorbit; Resorcit, Chinit, Bis-(4-hydroxycyclohexyl)-methan, 2,2-Bis-(4-hydroxycyclohexyl)propan und 1,1-Bis-(hydroxymethyl)cyclohex-3-en; N,N-Bis-(2-hydroxyäthyl)anilin, p,p'-Bis(2-hydroxyäthylamino)-diphenylmethan; Resorcin, Hydrochinon, Bis(4-hydroxyphenyl)-methan (Bisphenol F), 4,4'-Dihydroxybiphenyl, Bis(4-hydroxyphenyl)sulfon, 1,1,2,2-Tetrakis(4-hydroxyphenyl)äthan, 2,2-Bis(4-hydroxyphenyl)propan (Bisphenol A), 2,2-Bis(3,5-dibrom-4-hydroxyphenyl)propan (Tetrabrom-Bisphenol A); Novolake aus Formaldehyd oder Acetaldehyd mit Phenol, Chlorphenol oder Alkylphenolen mit bis zu 9 C-Atomen im Alkyl.

Als Poly(N-glycidyl)-Verbindungen kommen durch Dehydrochlorierung von Umsetzungsprodukten aus Epichlorhydrin und Aminen mit mindestens zwei Aminowasserstoffatomen erhaltene Produkte in Betracht. Geeignete Amine sind z. B. Anilin, n-Butylamin, Bis-(4-aminophenyl)-methan, 1,3- und 1,4-Xylylendiamin, 1,3- und 1,4-Bis(aminomethyl)-cyclohexan und Bis(4-methylaminophenyl)methan. Triglycidylisocyanurat, N,N'-Diglycidylderivate von cyclischen Alkylenharnstoffen, wie Aethylenharnstoff und 1,3-Propylenharnstoff, oder Hydantoinen, wie 5,5-Dimethylhydantoin, sind weitere geeignete derartige Verbindungen.

Poly(S-glycidyl)verbindungen sind z. B. die Di-S-glycidylderivate von Dithiolen, wie Aethan-1,2-dithiol und Bis-(4-mercaptomethylphenyl)äther.

Beispiele für Epoxidharze mit einer oder mehreren Gruppen der Formel A, in welcher Q und $Q_2$ zusammen eine Gruppe $—CH_2CH_2—$ oder $—CH_2CH_2CH_2—$ bedeuten, sind Bis(2,3-epoxycyclopen-

tyl)äther, 2,3-Epoxycyclopentylglycidyläther, 1,2-Bis(2,3-epoxycyclopentyloxy)äthan, 3,4-Epoxy-6-methylcyclohexylmethyl-3',4'-epoxy-6'-methylcyclohexan-carboxylat und 2-(3,4-Epoxy)cyclohexyl-5,5-spiro(3',4'-epoxy)cyclohexan-m-dioxan.

Ebenfalls einsetzbar sind Epoxidharze, in welchen die Epoxidgruppen an Heteroatome verschiedener Art gebunden sind, oder in denen einige oder sämtliche Epoxidgruppen mittelständig sind, wie beispielsweise das N,N,O-Triglycidylderivat des 4-Aminophenols, N-Glycidyl-N'-(2-glycidyloxypropyl)-5,5-dimethylhydantoin, Vinylcyclohexendioxid, Limonendioxid und Dicyclopentadiendioxid.

Gewünschtenfalls können auch Epoxidharzgemische verwendet werden.

Besonders bevorzugt setzt man im erfindungsgemässen Verfahren gegebenenfalls vorverlängerte Diglycidyläther von zweiwertigen Phenolen, vor allem 2,2-Bis(4-hydroxyphenyl)propan, 2,2-Bis(3,5-dibrom-4-hydroxyphenyl)propan und Bis(4-hydroxyphenyl)methan, oder von zweiwertigen aliphatischen Alkoholen mit bis zu 8 C-Atomen, wie Butan-1,4-diol, Polyglycidyläther von Novolaken, oder tetraglycidyliertes 4,4'-Diaminodiphenylmethan ein. Ganz besonders bevorzugt sind gegebenenfalls vorverlängerte Diglycidyläther von Bisphenol A, Tetrabrom-Bisphenol A oder Bisphenol F, tetraglycidyliertes 4,4'-Diaminodiphenylmethan, Polyglycidyläther von Phenol-Formaldehyd- oder Kresol-Formaldehyd-Novolaken, oder Gemische davon.

Als photopolymerisierbare Verbindungen b) können z. B. — wie schon erwähnt — Verbindungen der in der deutschen Offenlegungsschrift 27 06 549 beschriebenen Art verwendet werden. Dabei können solche Verbindungen durch eine Radikalkettenreaktion oder durch Reaktion eines angeregten Monomermoleküls mit einem anderen Monomermolekül polymerisiert werden.

Bevorzugte erfindungsgemäss verwendete photopolymerisierbare Verbindungen des erstgenannten Typus weisen eine oder, sofern sie unkonjugiert sind, mehr als eine Aethylenbindung auf. Bevorzugt sind Acrylester mit mindestens einer Gruppe der Formel B

$$CH_2{=}C(Q_3)COO— \qquad (B)$$

worin $Q_3$ für ein Wasserstoff-, Chlor- oder Bromatom oder eine $C_{1-4}$-Alkylgruppe, besonders ein Wasserstoffatom oder eine Methylgruppe, steht. Weitere geeignete Verbindungen dieses Typs sind Styrol, Divinylbenzol, Crotonsäureester und Sorbinsäureester.

Als photopolymerisierbare Stoffe des zweiten Typs kommen z. B. Verbindungen mit mindestens zwei und vorzugsweise drei oder mehr Chalkon-, Propenon- oder Pentadienongruppen und vor allem in 3-Stellung substituierte Acrylate in Betracht.

Als 3-substituierte Acrylate eignen sich z. B. solche mit Gruppen der Formel C

$$Q_4CH{=}C(Q_3)COO— \qquad (C)$$

worin $Q_4$ eine aliphatische oder einkernige aromatische, araliphatische oder heterocyclische Gruppe darstellt, die in Konjugation mit der gezeigten C=C-Doppelbindung äthylenisch oder aromatisch ungesättigt ist, wie die Phenyl-, 2-Furyl, 2- oder 3-Pyridyl, Prop-2-enyl- oder Styrylgruppe, und $Q_3$ die oben angegebene Bedeutung hat. Beispiele für Verbindungen solcher Art sind die Sorbinsäurediester von Poly(oxyäthylen)- und Poly(oxypropylen)-glykolen.

Bevorzugt verwendet man als photopolymerisierbare Verbindung b) einen Acrylsäureester der Formeln D, E, F oder G

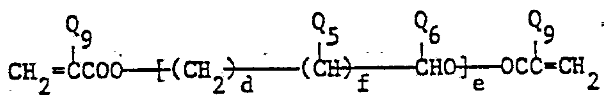

(D)

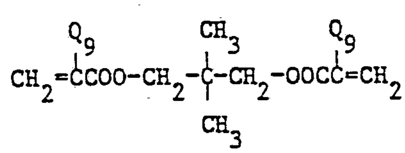

(E)

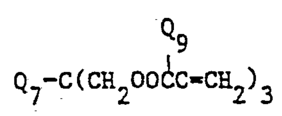

(F)

oder

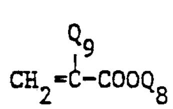

(G)

worin

d eine ganze Zahl von 1 bis 8, e eine ganze Zahl von 1 bis 20,

f Null oder 1,

$Q_5$ —H, —OH oder —$OOCC(Q_9){=}CH_2$,

$Q_6$ —H, Methyl, Aethyl, $—CH_2OH$ oder $—CH_2OOCC(Q_9)=CH_2$,
$Q_7$ Methyl, Aethyl, $—CH_2OOCC(Q_9)=CH_2$ oder $—CH_2—OH$,
$Q_8$ $C_{1\text{-}18}$-Alkyl, besonders $C_{1\text{-}8}$-Alkyl, Hydroxyalkyl mit 1-6 C-Atomen, Alkoxyalkyl mit insgesamt 2-8 C-Atomen, besonders 3-6 C-Atomen, eine Gruppe

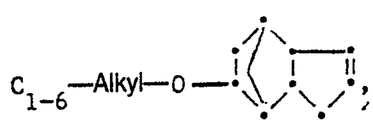,

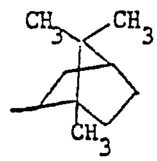

N,N-Dialkylaminoalkyl mit insgesamt 3-12, besonders 3-6 C-Atomen,

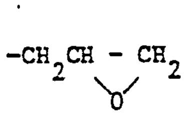, 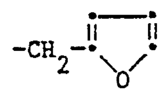, 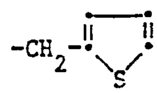

$C_{3\text{-}4}$-Alkenyl, Cyclopentyl oder Cyclohexyl und
$Q_9$ Wasserstoff oder Methyl bedeuten.

Beispiele von Verbindungen der Formel D sind: Aethylenglykoldiacrylat und -dimethacrylat, 1,4-Butandioldiacrylat und -dimethacrylat, 1,6-Hexandioldiacrylat und -dimethacrylat, Polyäthylenglykoldiacrylate und -dimethacrylate mit 2-20 Aethylenglykoleinheiten ($d = 1$, $f = 0$, $e = 2\text{-}20$, $Q_6 = —H$), besonders Di- und Triäthylenglykoldiacrylat und -dimethacrylat. Als Verbindungen der Formel E kommen Neopentylglykoldiacrylat und besonders Neopentylglykoldimethacrylat in Betracht. Bevorzugte Verbindungen der Formel F sind Pentaerythrittetraacrylat und -tetramethacrylat sowie 1,1,1-Trimethylolpropantriacrylat und -trimethacrylat.

Geeignete definitionsgemässe Gruppen $Q_8$ sind z. B. Methyl, Aethyl, n-Propyl, Isopropyl, n-Butyl, sek-Butyl, n-Pentyl, n-Hexyl, 2-Aethylhexyl, n-Octyl, n-Decyl, n-Dodecyl, n-Tetradecyl, n-Heptadecyl, n-Octadecyl; Hydroxymethyl, 2-Hydroxyäthyl, 3-Hydroxypropyl, 2-Hydroxypropyl, 4-Hydroxybutyl; Methoxymethyl, Aethoxymethyl, 2-Methoxyäthyl, 2-Aethoxyäthyl, 2-n-Butoxyäthyl;

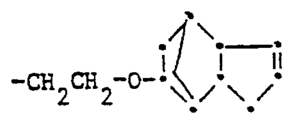

2-(Dimethylamino)äthyl, 2-(Diäthylamino)äthyl, 3-(Diäthylamino)propyl, 2-(Di-n-propylamino)äthyl, 2-(Di-n-butylamino)äthyl; Allyl, Methallyl und 1-Butenyl.

Vorzugsweise stellt $Q_8$ $C_{1\text{-}8}$-Alkyl, besonders $C_{1\text{-}4}$-Alkyl, $C_{2\text{-}3}$-Hydroxyalkyl, 2-Alkoxyäthyl mit 2-4 C-Atomen im Alkoxy,

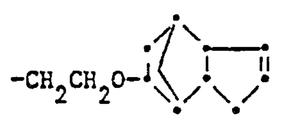

oder 2-(Dialkylamino)äthyl mit je 1 oder 2 C-Atomen in den Alkylgruppen dar.

$Q_9$ ist bevorzugt Methyl. Es können auch Gemische verschiedener photopolymerisierbarer Verbindungen b) verwendet werden.

Ganz besonders bevorzugt setzt man im erfindungsgemässen Verfahren als photopolymerisierbare Verbindung b) Aethylenglykoldimethacrylat, 1,4-Butandioldimethacrylat, 2-Hydroxyäthylmethacrylat, 3-Hydroxypropylmethacrylat, 2-Aethoxyäthylmethacrylat, 1,1,1-Trimethylolpropantrimethacrylat oder eine Verbindung der Formel G, worin $Q_8$

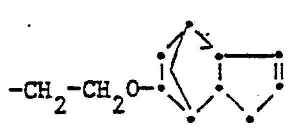

und $Q_9$ Methyl darstellen, oder Gemische der genannten Verbindungen ein.

Das Epoxidharz a) und die photopolymerisierbare Verbindung b) werden zweckmässig in einem Gewichtsverhältnis von 100 : 3 bis 100 : 30, besonders 100 : 6 bis 100 : 20, bzw. einem Aequivalenzverhältnis von 1 : 0,01 bis 1 : 0,7, bevorzugt 1 : 0,08 bis 1 : 0,3, verwendet.

Die im erfindungsgemässen Verfahren verwendeten flüssigen Massen können auch Substanzen enthalten, die pro Molekül mindestens eine Epoxidgruppe und mindestens eine mittels aktinischer Strahlung polymerisierbare Gruppe enthalten (im folgenden als « doppelfunktionelle Substanz » bezeichnet). Derartige Substanzen können z. B. dadurch hergestellt werden, dass man in Verbindungen, die bereits mehrere Epoxidgruppen enthalten, photopolymerisierbare Gruppen einführt, oder indem man in

Verbindungen mit einer oder mehreren photopolymerisierbaren Gruppen mindestens eine Epoxidgruppe einführt. So kann man z. B. Diepoxide mit einem Unterschuss, bezogen auf den Epoxidgruppengehalt, einer Verbindung umsetzen, die sowohl eine photopolymerisierbare Gruppe als auch eine zur Reaktion mit Epoxidgruppen befähigte funktionnelle Gruppe, wie eine Carboxylgruppe, NH-Gruppe, eine phenolische oder alkoholische Hydroxylgruppe, aufweist.

Derartige doppelfunktionelle Substanzen sind z. B. in der U.S. Patentschrift 3.450.613 und den deutschen Offenlegungsschriften 23 42 407 und 27 06 649 beschrieben. Bevorzugt sind acryl-substituierte Carbonsäuren der oben angegebenen Formel B, ferner hydroxylsubstituierte Chalkone und hydroxyphenyl-substituierte Propenone oder Pentadienone, wie 1-(4-Hydroxyphenyl)3-oxo-3-phenylprop-1-en, 1-(4-Hydroxyphenyl)-1-oxo-3-phenylprop-2-en und 1-(2-Furyl)-3-oxo-3-(4-hydroxyphenyl)-prop-1-en. Bevorzugte doppelfunktionelle Substanzen sind Umsetzungsprodukte aus einem der vorerwähnten bevorzugten Diglycidyläther, besonders dem Diglycidyläther von Bisphenol A, Tetrabrom-Bisphenol A oder Bisphenol F oder dem tetraglycidylierten 4,4'-Diaminodiphenylmethan, und einem Unterschuss Acrylsäure oder Methacrylsäure.

Die doppelfunktionellen Substanzen werden üblicherweise in einer Menge von 10 bis 70 Mol.%, bezogen auf die Totalmenge an Epoxidharz a) eingesetzt, jedoch höchstens in einer solchen Menge, dass das Aequivalentverhältnis von Epoxidgruppen zur photopolymerisierbaren Gruppen 1 : 0,7 nicht übersteigt.

Die photopolymerisierbare Verbindung b) wird vorzugsweise in Gegenwart eines Photopolymerisationskatalysators d) bestrahlt. Es kommen zwei Klassen von Verbindungstypen in Betracht :

— solche, die bei Bestrahlung einen angeregten Zustand ergeben, der zur Bildung freier Radikale führt, die dann die Polymerisation des Monomeren einleiten (Photoinitiatoren) und

— solche, die bei Bestrahlung einen angeregten Zustand ergeben, der seinerseits seine Anregungsenergie auf ein Monomermolekül überträgt, so dass ein angeregtes Monomermolekül entsteht, welches dann mit einem nicht angeregten Monomermolekül vernetzt (Photosensibilisatoren). Geeignete Katalysatoren sind in der schon erwähnten deutschen Offenlegungsschrift 27 06 549 beschrieben. Im allgemeinen werden 0,1 bis 20 Gew.%, vorzugsweise 0,5 bis 15 Gew.% Photopolymerisationskatalysator verwendet, bezogen auf das Gesamtgewicht der photopolymerisierbaren Verbindung und gegebenenfalls der doppelfunktionellen Substanz. Bevorzugt verwendet man Benzildimethylketal als Photopolymerisationskatalysator.

Zur thermischen Polymerisation der photopolymerisierbaren Verbindungen, die der aktinischen Bestrahlung zu wenig ausgesetzt waren, können übliche Initiatoren, wie Peroxide (z. B. Dibenzoylperoxid) oder Azoisobutyronitril oder Pinakonderivate zugesetzt werden.

Als weitere Zusätze können im erfindungsgemässen Verfahren für die Herstellung von Prepregs bzw. verstärkten Verbundstoffen übliche Zusatzstoffe, wie Thixotropiemittel, Thermoplaste, z. B. Polyvinylformal, Acrylatcopolymere oder sogenannte reaktive flüssige Kautschuke, wie Acrylnitril-Butadien-Copolymere mit endständigen COOH-Gruppen, Füllstoffe, wie Glas oder Quarzmehl und Ballotini, Farbstoffe oder Pigmente, Netz- und Verlaufshilfsmittel, verwendet werden. Dabei ist darauf zu achten, dass diese Zusätze bzw. deren Konzentration das Eindringen der aktinischen Strahlung nicht zu sehr beeinträchtigen.

Für die Photopolymerisation verwendet man vorzugsweise aktinische Strahlung einer Wellenlänge von 200-600 nm, besonders UV-Bestrahlung. Als aktinische Strahlungsquellen eignen sich unter anderem Kohlelichtbögen, Quecksilberdampflampen, Metallhalogeniddampflampen, Leuchtröhren mit ultraviolettes Licht ausstrahlenden Leuchtstoffen, Argon- und Xenonglimmlampen, Wolframlampen und photographische Flutlampen. Die zur Belichtung der photopolymerisierbaren Verbindungen benötigte Zeit kann in Abhängigkeit der Menge der verwendeten Verbindungen a), b), c) und gegebenenfalls d), der Art der Lichtquelle und deren Abstand vom imprägnierten Material variieren. Nach der Photopolymerisation muss das Material auf jeden Fall noch heisshärtbar sein ; aus diesem Grund erfolgt die Photopolymerisation bei Temperaturen unterhalb derjenigen, bei der die Heisshärung in Gegenwart des hitzeaktivierbaren Härters durchgeführt wird.

Die Temperaturen und die Erhitzungsdauer, die für die Heisshärtung erforderlich sind, sowie die benötigte Menge Härter lassen sich leicht durch Vorversuche bestimmen. Im allgemeinen erfolgt die Heisshärtung bei Temperaturen zwischen 60 und 160 °C, bevorzugt 60 und 120 °C, während 10 Minuten bis 2 Stunden.

Das Epoxidharz a), die photopolymerisierbare Verbindung b), der hitzeaktivierbare Härter c) sowie gegebenenfalls der Photopolymerisationskatalysator d) und die allfällig vorhandene doppelfunktionelle Substanz werden zweckmässigerweise so aufgebracht, dass der Prepreg insgesamt 20 bis 80 Gew.% der genannten Komponenten und 80 bis 20 Gew.% Verstärkungsmaterial enthält. Besonders bevorzugt werden insgesamt 20 bis 50 Gew.% der genannten Komponenten und 80 bis 50 Gew.% Verstärkungsmaterial eingesetzt.

Erfindungsgemäss hergestellte Prepregs können z. B. in Form von Folien oder verschiedenen Formkörpern, wie imprägnierten Geweben, Matten, Vliesen oder Strängen, vorliegen. Das erfindungsgemässe Verfahren eignet sich insbesondere zur Herstellung von verstärkten Verbundstoffen, bei denen kurze Takt- und Formbelegungszeiten wichtig sind, wie z. B. Skis, Tennisschlägern, Autokarrosserieteilen und verschiedenartigen Gehäusen.

In den folgenden Beispielen wird die Bestimmung der Topfzeit nach Tecam gemäss British Standard 3532 (1967) mit einem TECAM®-Geltimer-Gerät der Fa. Techma Ltd., Cambridge, durchgeführt. Dabei wird die Zeit bestimmt, bis sich ein in 100 g Harz/Härter-Mischung auf und ab bewegender Stempel infolge Gelierung der Masse nicht mehr bewegen kann (Starttemperatur 23 °C). Für die Belichtung wird eine Colight M-218 Anlage mit 400 W-Lampen (Fa. Colight) verwendet. Der Lampenabstand beträgt ca. 28 cm ; Strahlungsleistung 2 × 27 mW/$cm^2$ bei 380 nm, 2 × 60 mW/$cm^2$ bei 400 nm und 2 × 55 mW/$cm^2$ bei 420 nm. Zur Bestimmung des Flusses werden 2 Prepregstücke von je 50 mm Kantenlänge bei 100 °C in einer Presse mit einem Druck von 4 bar während 5 Minuten verpresst. Die Menge des aus dem erhaltenen Laminat herausgeflossenen Harzes wird entweder visuell geschätzt oder nach dem Abschneiden entlang der Laminatkante gewogen und in % des Anfangsgewichts ausgedrückt. Die Brauchbarkeit eines Prepregs wird üblicherweise anhand seines Flusses bestimmt. Wenn der Fluss zu klein ist, z. B. kleiner als 10 %, kann in der Regel ein Prepreg nicht mehr zu einem guten Laminat verpresst werden. Die interlaminare Scherfestigkeit (Biegeprüfung am Kurzbalken) wird nach ASTM D 2344 mit einem Stützstellenabstand 1 = 5 × Dicke bestimmt. Die Glasumwandlungstemperatur wird auf einem thermomechanischem Analysator TMA 40 der Fa. Mettler AG bestimmt. Die Last auf dem eindringenden Stempel beträgt 0,5 N/$mm^2$, Aufheizgeschwindigkeit = 10 °C/Min. Die Auswertung erfolgt vollautomatisch.

In den folgenden Beispielen steht für Aminwasserstoffäquivalent abgekürzt : N—H-Aequivalent.

Beispiel 1

Aus 100 g eines Diglycidyläthers von 2,2-Bis(4-hydroxyphenyl)propan (Bisphenol A) mit einem Epoxidgehalt von 5,3 Aequivalenten/kg, 10 g 1,1,1-Trimethylolpropan-trimethacrylat, in dem 0,1 g Benzildimethylketal gelöst sind, und 15 g eines Härtergemisches aus 28,6 Gew.% N,N-Dimethylamino-N'-(3-aminopropyl)-1,3-diaminopropan (0,15 N—H-Aequivalente/Epoxidäquivalent) und 71,4 Gew.% N,N-Dimethylamino-N'-(2-cyanoäthyl)-1,3-diaminopropan (0,13 N—H-Aequivalente/Epoxidäquivalent) wird durch Rühren bei Raumtemperatur eine schlierenfreie Harz/Härter-Mischung hergestellt. Viskosität der Mischung bei 25 °C = 1 160 mPa s. Gebrauchsdauer bei 25 °C bis zu einer Viskosität von 3 000 mPa S : 52 Minuten. Topfzeit nach Tecam, 100 g bei 23 °C : 235 Minuten.

Mit diesem Harz/Härter-Gemisch wird Glasfasergewebe (Typ 92 146 I 550 der Fa. Interglas) bei Raumtemperatur imprägniert und während 0,5 Minuten mit einer Colight M 218-Anlage mit UV-Strahlung belichtet. Der erhaltene Prepreg ist bei Raumtemperatur sehr flexibel und kaum klebrig. Die Lagerfähigkeit des Prepregs bei Raumtemperatur bis zum Verschwinden der Flexibilität beträgt 24 Stunden, bei der Lagerung im Kühlschrank bei 5-12 °C ca. 96 Stunden.

12 Lagen der Prepregs werden aufeinandergeschichtet und bei einem Druck von 4 bar bei 100 °C innerhalb von 20 Minuten zu Laminaten verpresst. Das erfindungsgemässe System zeigt einen sogenannten gebremsten Fluss (Viskosität bei der Presstemperatur im Bereich einiger Pa · s bis 1 000 Pa · s), was den Vorteil mit sich bringt, dass die Pressform und die Presse nur wenig verunreinigt werden, weil das Harz nur noch 2-3 cm über die Glasgeweberänder hinausfliesst. Interlaminare Scherfestigkeit : 56 N/$mm^2$ ; Glasumwandlungstemperatur : 70 °C.

Beispiele 2 und 3

Nach der in Beispiel 1 beschriebenen Arbeitsweise wird Glasfasergewebe mit den folgenden Harz/Härter-Gemischen imprägniert und zu Prepregs verarbeitet :

| Komponenten | | Beispiel 2 | Beispiel 3 |
|---|---|---|---|
| Epoxidharz gemäss Beispiel 1 | g | 100 | 100 |
| 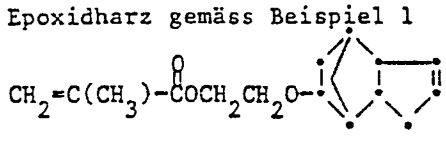 | g | 30 | 8 |
| Aethylenglykoldimethacrylat | g | - | 2 |
| Benzildimethylketal | g | 0,6 | 0,2 |
| Isophorondiamin (1 N-H-Aequivalent/Epoxidäquivalent) | g | 22 | 22 |
| UV-Belichtung Minuten | | 13 | 3 |

Die so erhaltenen Prepregs sind unmittelbar nach der UV-Belichtung noch sehr flexibel und deutlich klebriger als der Prepreg gemäss Beispiel 1. Nach 3-4 Stunden Lagerung bei 25 °C sind die Prepregs nicht mehr flexibel und nicht mehr klebrig.

Beim Verpressen bei 100 °C/4 bar zu einem Laminat zeigt die Formulierung gemäss Beispiel 2 einen wesentlich ausgeprägteren gebremsten Fluss als die Formulierung gemäss Beispiel 3, indem das Harz nur noch etwa 1-2 cm über die Glasgeweberänder hinausfliesst. Nach 74 Stunden Lagerung des Prepregs bei Taumtemperatur ist der Fluss zur Herstellung von Laminaten noch ausreichend.

Beispiel 4

Um die anfängliche Klebrigkeit im Vergleich zu den Prepregs gemäss Beispielen 2 und 3 zu reduzieren und um mit einer möglichst geringen Menge an photopolymerisierbarer Verbindung auszukommen, wird analog Beispiel 1 eine Mischung aus folgenden Komponenten hergestellt:

80 g flüssiges Epoxidharz auf der Basis von Bisphenol A mit einem Epoxidgehalt von 5,4 Aequiv/kg, 20 g festes Epoxidharz auf der Basis von Tetrabrombisphenol A mit einem Epoxidgehalt von 2,0-2,2 Aequiv./kg und einem Erweichungspunkt zwischen 40 und 60 °C, 2 g Aethylenglykoldimethacrylat, 8 g 2-Hydroxyäthylmethacrylat 0,2 g Benzildimethylketal und 20,1 g Isophorondiamin (1 N—H Aequivalent/Epoxidäquivalent). Mit dieser Mischung wird Glasfasergewebe imprägniert und 4 Minuten mit UV-Licht bestrahlt. Unmittelbar nach der Belichtung sind die so erhaltenen Prepregs nur leicht klebrig. Bei Lagerung im Kühlschrank bei 5-10 °C kann diese leichte Klebrigkeit während ca. 24 Stunden erhalten werden. Bei Lagerung bei Raumtemperatur werden die Prepregs nach 3 Stunden grifftrocken. Nach 4 Tagen Lagerung bei Raumtemperatur wird aus 12 Prepreglagen wie in Beispiel 1 beschrieben ein Laminat hergestellt. Dabei wird in der Presse ein stark gebremster Fluss beobachtet (Harz-Ausfluss: 1-2 cm). Das erhaltene Laminat ist homogen und transparent.

Beispiel 5

Kohlefasergewebe (Fa. Sigri, Flächengewicht 290 g/m$^2$) wird bei Raumtemperatur mit einem Gemisch aus

75 g (0,40 Epoxidäquivalente) eines flüssigen Bisphenol-A-diglycidyläthers mit einem Epoxidgehalt von 5,3 Aequiv./kg,

25 g (0,05 Epoxidäquivalente) eines festen Bisphenol-A-diglycidyläthers mit einem Epoxidgehalt von 2,1 Aequiv./kg,

11 g (0,074 C=C-Aequivalente) 2-Hydroxypropylmethacrylat (Fa. Röhm + Haas. ca. 95 %ig),

1,5 g (0,013 C=C-Aequivalente) 1,4-Butandioldimethacrylat (Fa. Röhm + Haas, ca. 95 %ig),

0,24 g Benzildimethylketal,

8,6 g (0,23 N—H-Aequivalente) 1-Phenyl-1,3-diaminopropan und

12,08 g (0,22 N—H-Aequivalente) Bis(p-aminocyclohexyl)-methan imprägniert. Nach 4 Minuten UV-Bestrahlung zwischen zwei Polyäthylendeckfolien wird ein flexibler, noch leicht klebriger Prepreg erhalten, der nach 2 Stunden Lagerung bei Raumtemperatur nur noch leicht klebrig ist. Nach 12 Stunden Lagerung bei Raumtemperatur ist der Prepreg trocken. Nach 3 Tagen Lagerung bei 23-28 °C wird aus 2 Lagen Prepreg (je 1,6 mm dick) eine Laminatplatte gepresst. Pressbedingungen: 15 Minuten bei 100 °C/10 bar, auf die Laminatplatt bezogen. Beim Pressen wird ein gebremster Fluss beobachtet, d. h. das Harz fliesst ca. 1 cm über den Laminatrand hinaus. Trotz der sehr kurzen Härtungszeit bei 100 °C weist das Harz, am Ausfluss gemessen, eine Glasumwandlungstemperatur von 96 °C auf.

Beispiel 6

Herstellung eines Prepregs für den Skibau Man bereitet ein Harz aus den folgenden Komponenten zu:

40 Gewichtsteile eines flüssigen Bisphenol-A-diglycidyläthers mit einem Epoxidgehalt von 5,3 Aequiv./kg,

60 Gewichtsteile eines festen Bisphenol-A-diglycidaläthers mit einem Epoxidgehalt von 2,2 Aequiv./kg,

20 Gewichtsteile 2-Aethoxyäthylmethacrylat,

0,4 Gewichtsteile Benzildimethylketal und

0,5 Gewichtsteile 3-Glycidyloxypropyltrimethoxysilan.

Dieses Harz wird unter Ausschluss von Licht aufbewahrt. Seine Viskosität beträgt 16 600 mPa s bei 25 °C.

Als Härter verwendet man ein Gemisch aus

3 Gewichtsteilen N,N-Dimethyl-N'-(3-aminopropyl)-1,3-diaminopropan und

5 Gewichtsteilen N,N-Diäthyl-1,3-diaminopropan.

Man mischt 100 Gewichtsteile vom Harz mit 8 Gewichtsteilen Härter. Das erhaltene Gemisch hat eine Viskosität von 10 200 mPa s bei 25 °C und eine Gelierzeit von 6-7 Minuten bei 100 °C.

Mit diesem Harz/Härter-Gemisch wird ein 20 cm breites Glasgewebe auf einer kontinuierlichen

Imprägnieranlage mit einem ca. 500 ml fassenden Imprägnierbad im Tauchverfahren imprägniert. Unmittelbar nach dem Imprägnierbad wird das imprägnierte Glasgewebe mit Infrarot-Strahlen erwärmt, um die Viskosität des Harz/Härter-Gemisches so weit zu senken, dass eine gute Benetzung und Durchtränkung des Glasgewebes erfolgt.

Anschliessend wird das Glasgewebe mit UV-Licht (aus 400 Watt Quecksilberlampen) mit einer Verweilzeit von 2 Minuten in der Bestrahlungszone beidseitig bestrahlt. Durch die UV-Bestrahlung verfestigt sich das Prepreg, in dem es zunächst noch leicht klebrig ist, aber schon nach 10 Minuten grifftrocken und steif. Seine Lagerfähigkeit beträgt 2 bis 3 Tage bei Raumtemperatur.

Dieses Prepreg wird für den Skibau verwendet. Nach dem Verpressen bei 100 °C während 10 Minuten mit den verschiedensten, im Skibau verwendeten Materialien, ist seine Haftung sehr gut. [Solche Materialien sind z. B. Aluminium, Polyurethan-Integralschaum, Acrylnitril-Butadien-Styrol-Copolymer (ABS), vorbehandeltes Polyäthylen, Esche, Pappel, Okumé, Gummi und Phenolformaldehydlaminat.]

Die verklebten Materialien weisen folgende Eigenschaften auf :

Die Zugscherfestigkeit des Prüfkörpers aus Prepreg und geschliffenem Aluminium beträgt 15,8 N/mm².

Die Rollenschälfestigkeit von verklebten Materialien wird an 2,5 cm breiten Prüfkörpern nach DIN 53 289 geprüft. Die Ergebnisse sind in der folgenden Tabelle zusammengefasst.

Tabelle

| Verklebtes Material | Rollenschälfestigkeit N/mm |
|---|---|
| Aluminium; geschliffen | 2,54 ± 0,54 |
| Esche/Pappel; verleimter Skikern | 1,36 ± 1,0 |
| ABS-Deckblatt; geschliffen | 2,04 ± 0,40 |
| Polyäthylen; vorbehandelt | Polyäthylenbruch |
| Gummi; säuregeätzt | 1,95 ± 0,32 |
| Phenolformaldehydlaminat | mässig bis gut |
| Polyurethan-Integralschaum | 1,7 ± 0,7 |

## Patentansprüche

1. Verfahren zur Herstellung von Prepregs, indem man ein Verstärkungsmaterial mit einer
a) ein Epoxidharz,
b) eine photopolymerisierbare Verbindung,
c) einen hitzeaktivierbaren Härter für das Epoxidharz a) und gegebenenfalls
d) einen Photopolymerisationskatalysator für die photopolymerisierbare Verbindung b) enthaltenden flüssigen lösungsmittelfreien Masse imprägniert und mit aktinischer Strahlung belichtet, bis sich die Masse durch Photopolymerisation der photopolymerisierbaren Verbindung zu einer im wesentlichen festen Schicht verfestigt, während das Epoxidharz weitgehend in heisshärtbarem Zustand verbleibt, dadurch gekennzeichnet, dass man als hitzeaktivierbaren Härter c) ein gegebenenfalls substituiertes aliphatisches, cycloaliphatisches oder araliphatisches Amin verwendet und die photopolymerisierbare Verbindung b) in einem solchen Verhältnis zu der thermisch härtbaren Komponente a) einsetzt, dass die Masse nach der Bestrahlung mit aktinischem Licht noch thermoplastisch verformbar ist.

2. Verfahren nach Anspruch 1, dadurch gekennzeichnet, dass man das Epoxidharz a) und die photopolymerisierbare Verbindung b) in einem Gewichtsverhältnis von 100 : 3 bis 100 : 30, besonders 100 : 6 bis 100 : 20, bzw. einem Aequivalenzverhältnis von 1 : 0,01 bis 1 : 0,7, bevorzugt 1 : 0,08 bis 1 : 0,3, verwendet.

3. Verfahren nach Anspruch 1, dadurch gekennzeichnet, dass man als Verstärkungsmaterial Glas-, Bor-, rostfreie Stahl-, Wolfram-, Siliciumcarbid-, Kohlenstoff- oder aromatische Polyamidfasern verwendet.

4. Verfahren nach Anspruch 1, dadurch gekennzeichnet, dass man als Verstärkungsmaterial Glasfasern verwendet.

5. Verfahren nach Anspruch 1, dadurch gekennzeichnet, dass man ein Epoxidharz verwendet, das an Kohlenstoff-, Sauerstoff-, Stickstoff- oder Schwefelatome gebundene Gruppen der Formel A

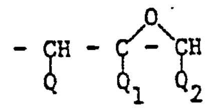 (A)

enthält und frei von Acryloyl- oder Methacryloylgruppen ist, wobei Q und $Q_2$ je eine Wasserstoffatom und $Q_1$ ein Wasserstoffatom oder die Methylgruppe bedeuten oder Q und $Q_2$ zusammen $—CH_2CH_2—$ oder $—CH_2CH_2CH_2—$ und $Q_1$ ein Wasserstoffatom bedeuten.

6. Verfahren nach Anspruch 1, dadurch gekennzeichnet, dass man als Epoxidharz a) gegebenenfalls vorverlängerte Diglycidyläther von zweiwertigen Phenolen oder von zweiwertigen aliphatischen Alkoholen mit bis zu 8 C-Atomen, Polyglycidyläther von Novolaken oder tetraglycidyliertes 4,4'-Diaminodiphenylmethan verwendet.

7. Verfahren nach Anspruch 1, dadurch gekennzeichnet, dass man als Epoxidharz a) gegebenenfalls vorverlängerte Diglycidyläther von Bisphenol A, Tetrabrom-Bisphenol A oder Bisphenol F, tetraglycidyliertes 4,4'-Diaminodiphenylmethan oder Polyglycidyläther von Phenol-Formaldehyd- oder Kresol-Formaldehyd-Novolaken oder Gemische davon verwendet.

8. Verfahren nach Anspruch 1, dadurch gekennzeichnet, dass man als photopolymerisierbare Verbindung b) Acrylester mit mindestens einer Gruppe der Formel B

$$CH_2=C(Q_3)COO— \qquad (B)$$

verwendet, worin $Q_3$ für ein Wasserstoff-, Chlor- oder Bromatom oder eine $C_{1-4}$-Alkylgruppe, besonders ein Wasserstoffatom oder eine Methylgruppe, steht.

9. Verfahren nach Anspruch 1, dadurch gekennzeichnet, dass man als photopolymerisierbare Verbindung b) einen Acrylsäureester der Formeln D, E, F oder G

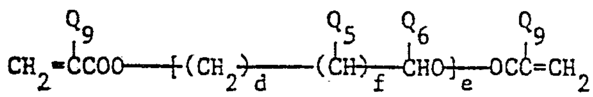 (D)

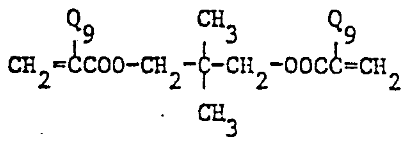 (E)

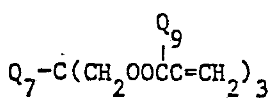 (F)

oder

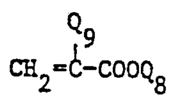 (G)

verwendet, worin

d eine ganze Zahl von 1 bis 8, e eine ganze Zahl von 1 bis 20,
f Null oder 1,
$Q_5$ —H, —OH oder $—OOCC(Q_9)=CH_2$,
$Q_6$ —H, Methyl, Aethyl, $—CH_2OH$ oder $—CH_2OOCC(Q_9)=CH_2$,
$Q_7$ Methyl, Aethyl, $—CH_2OOCC(Q_9)=CH_2$ oder $—CH_2—OH$,
$Q_8$ $C_{1-18}$-Alkyl, besonders $C_{1-8}$-Alkyl, Hydroxyalkyl mit 1-6 C-Atomen, Alkoxyalkyl mit insgesamt 2-8 C-Atomen, besonders 3-6 C-Atomen,
eine Gruppe

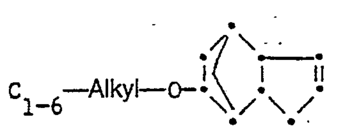 , 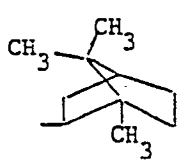

N,N-Dialkylaminoalkyl mit insgesamt 3-12, besonders 3-6 C-Atomen,

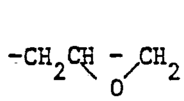 , 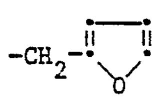 , 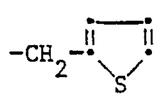

$C_{3-4}$-Alkenyl, Cyclopentyl oder Cyclohexyl und $Q_9$ Wasserstoff oder Methyl bedeuten.

10. Verfahren nach Anspruch 1, dadurch gekennzeichnet, dass man als photopolymerisierbare Verbindung b) Aethylenglykoldimethacrylat, 1,4-Butandioldimethacrylat, 2-Hydroxyäthylmethacrylat, 2-Hydroxypropylmethacrylat, 2-Aethoxyäthylmethacrylat, 1,1,1-Trimethylolpropantrimethacrylat oder

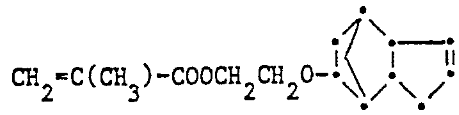

oder Gemische der genannten Verbindungen verwendet.

11. Verfahren nach Anspruch 1, dadurch gekennzeichnet, dass man eine flüssige Masse verwendet, die zusätzlich eine doppelfunktionelle Substanz, besonders ein Umsetzungsprodukt aus einem Diglycidyläther von Bisphenol A, Tetrabrom-Bisphenol A oder Bisphenol F oder dem tetraglycidylierten 4,4'-Diaminodiphenylmethan und einem Unterschuss Acrylsäure oder Methacrylsäure enthält.

12. Verfahren nach Anspruch 1, dadurch gekennzeichnet, dass man als hitzeaktivierbaren Härter c) diprimäre Alkylendiamine mit 2-14 C-Atomen, die in der Kette durch NH— oder O—Atome unterbrochen sein können, oder Amine der Formeln I bis V

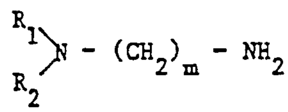 (I)

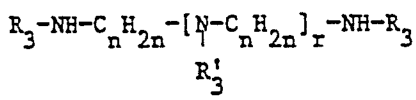 (II)

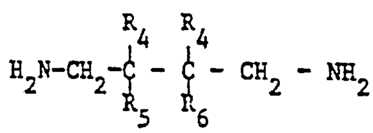 (III)

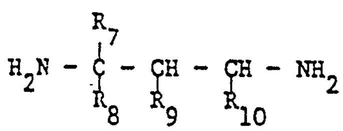 (IV)

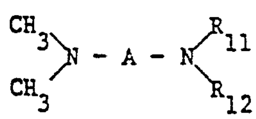 (V)

verwendet, worin

m eine ganze Zahl von 2 bis 6, besonders 2 oder 3,
n eine ganze Zahl von 2-12, besonders 3 bis 6,
r Null, 1 oder 2,
$R_1$ Wasserstoff $C_{1-4}$-Alkyl, besonders Methyl oder Aethyl,
$R_2$ $C_{1-4}$-Alkyl, besonders Methyl oder Aethyl, Cyclopentyl, oder Cyclohexyl, die $R_3$ je Cyclopentyl, Cyclohexyl, Benzyl oder Phenyläthyl,
$R_3'$ dasselbe wie $R_3$ oder Wasserstoff,
$R_4$ die unabhängig voneinander Wasserstoff oder Methyl,
$R_5$ Phenyl, Chlorphenyl oder Isopropylphenyl,
$R_6$ Phenyl, Chlorphenyl oder Methoxyphenyl,
$R_7$ und $R_9$ unabhängig voneinander Wasserstoff oder $C_{1-4}$-Alkyl,
$R_8$ Phenyl oder einen 5- oder 6-gliedrigen heterocyclischen Rest und
$R_{10}$ Wasserstoff, $C_{1-4}$-Alkyl, Phenyl oder einen 5- oder 6-gliedrigen heterocyclischen Rest bedeuten oder
$R_7$ und $R_8$ und/oder $R_9$ und $R_{10}$ zusammen $—(CH_2)_q—$ mit q = 4 oder 5 darstellen,
$R_{11}$ $C_{1-12}$-Alkyl, besonders $C_{1-8}$-Alkyl, $C_{6-8}$-Cycloalkyl, $C_{7-8}$-Aralkyl, $—A_1—CN$ oder $—A_2—CH_2NH_2$ und
$R_{12}$ Wasserstoff oder $—A_2CH_2NH_2$ und
A, $A_1$ und $A_2$ unabhängig voneinander Aethylen, 1,2- oder 1,3-Propylen bedeuten.

13. Verfahren nach Anspruch 1, dadurch gekennzeichnet, dass man als hitzeaktivierbaren Härter c) Tetramethylendiamin, Hexamethylendiamin, Polyäthylendiamine $H_2N—CH_2CH_2(NH—CH_2CH_2)_b—NH_2$

mit b = 1-6, besonders 1-4, 1,2-Diaminocyclohexan, 1,3- oder 1,4-Bis(aminomethyl)cyclohexan, 4,4'-Diaminodicyclohexylmethan, 1,3- oder 1,4-Xylylendiamin, 1,3-Diamino-1,3-diphenylpropan, 1,3-Diamino-1-phenyl-3-(2-tetrahydrofuryl)-propan, N-Aethylaminopiperazin, 3-Aminomethyl-3,5,5-trimethylcyclohexylamin (Isophorondiamin), N,N-Dimethyl-1,3-diaminopropan, N,N-Diäthyl-1,3-diaminopropan, N,N-Dimethyl-N'-(3-aminopropyl)-1,3-diaminopropan oder N,N-Dimethyl-N'-(2-cyanoäthyl)-1,3-diaminopropan oder Gemische davon verwendet.

14. Verfahren nach Anspruch 1, dadurch gekennzeichnet, dass man als hitzeaktivierbaren Härter c) Isophorondiamin oder Gemische aus N,N-Dimethyl-N'-(3-aminopropyl)-1,3-diaminopropan und N,N-Dimethyl-N'-(2-cyanoäthyl)-1,3-diaminopropan verwendet.

15. Die nach dem Verfahren gemäss Anspruch 1 erhaltenen Prepregs.

16. Verfahren zur Herstellung verstärkter Verbundstoffe, dadurch gekennzeichnet, dass man gemäss Anspruch 1 hergestellte Prepregs heisshärtet.

## Claims

1. A process for the preparation of prepregs by impregnating a reinforcing material with a liquid, solvent-free composition containing

a) an epoxide resin,

b) a photopolymerisable compound,

c) a heat-activatable curing agent for the epoxide resin a) and, if appropriate,

d) a photopolymerisation catalyst for the photopolymerisable compound b), and exposing the composition to actinic radiation until the composition solidifies to give a substantially solid layer as a result of photopolymerisation of the photopolymerisable compound, whereas the epoxide resin remains substantially in a heat-curable, state, which comprises using, as the heat-activatable curing agent c), a substituted or unsubstituted aliphatic, cycloaliphatic or araliphatic amine and employing the photopolymerisable compound b) in such a ratio to the heat-curable component a) that, after irradiation with actinic light, the composition can still be shaped by thermoplastic methods.

2. A process according to claim 1, wherein the epoxide resin a) and the photopolymerisable compound b) are used in a ratio by weight of 100 : 3 to 100 : 30, especially 100 : 6 to 100 : 20, or at an equivalence ratio of 1 : 0.01 to 1 : 0.7, preferably 1 : 0.08 to 1 : 0.3.

3. A process according to claim 1, wherein the reinforcing material used is glass, boron, stainless steel, tungsten, silicon carbide, carbon or aromatic polyamide fibres.

4. A process according to claim 1, wherein glass fibres are used as the reinforcing material.

5. A process according to claim 1, wherein an epoxide resin which contains groups of the formula A

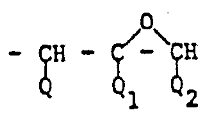

(A)

attached to carbon, oxygen, nitrogen or sulfur atoms and which is free from acryloyl or methacryloyl groups, Q and $Q_2$ each being a hydrogen atom and $Q_1$ being a hydrogen atom or the methyl group or Q and $Q_2$ together being $—CH_2CH_2—$ or $—CH_2CH_2CH_2—$ and $Q_1$ being a hydrogen atom, is used.

6. A process according to claim 1, wherein diglycidyl ethers, which may be advanced, of dihydric phenols or dihydric aliphatic alcohols having up to 8 C atoms, polyglycidyl ethers of novolacs or tetraglycidylated 4,4'-diaminodiphenylmethane are used as the epoxide resin a).

7. A process according to claim 1, wherein diglycidyl ethers, which may be advanced, of bisphenol A, tetrabromobisphenol A or bisphenol F, tetraglycidylated 4,4'-diaminodiphenylmethane or polyglycidyl ethers of phenolformaldehyde or cresol-formaldehyde novolacs, or mixtures thereof are used as the epoxide resin a).

8. A process according to claim 1, wherein the photopolymerisable compound b) used is an acrylic ester having at least one group of the formula B

$$CH_2{=}C(Q_3)COO— \quad (B)$$

in which $Q_3$ is a hydrogen, chlorine or bromine atom or a $C_{1-4}$alkyl group, especially a hydrogen atom or a methyl group.

9. A process according to claim 1, wherein the photopolymerisable compound b) used is an acrylic acid ester of the formulae D, E, F or G

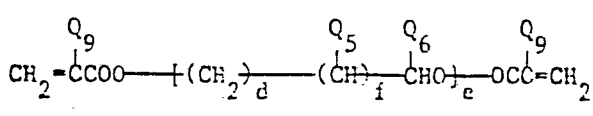

(D)

(Continued)

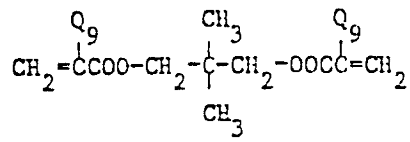

(E)

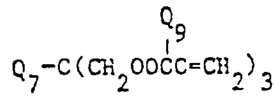

(F)

or

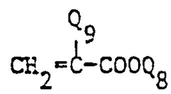

(G)

in which

d is an integer from 1 to 8,

e is an integer from 1 to 20,

f is zero or 1,

$Q_5$ is —H, —OH or —OOCC($Q_9$)=$CH_2$,

$Q_6$ is —H, methyl, ethyl, —$CH_2OH$ or —$CH_2OOCC(Q_9)=CH_2$,

$Q_7$ is methyl, ethyl, —$CH_2OOCC(Q_9)=CH_2$ or $CH_2$—OH,

$Q_8$ is $C_{1\text{-}18}$alkyl, especially $C_{1\text{-}8}$alkyl, hydroxyalkyl having 1-6 C atoms, alkoxyalkyl having a total of 2-8 C atoms, especially 3-6 C atoms, a group

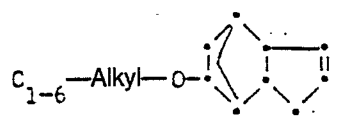 , 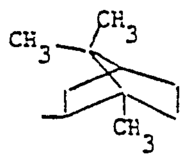

N,N-dialkylaminoalkyl having a total of 3-12, especially 3-6 C atoms,

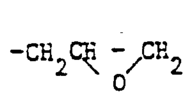 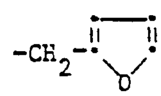 , 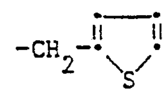

$C_{3\text{-}4}$-alkenyl, cyclopentyl or cyclohexyl and $Q_9$ is hydrogen or methyl.

10. The process according to claim 1, wherein the photopolymerisable compound b) used is ethylene glycol dimethacrylate, 1,4-butanediol dimethacrylate, 2-hydroxyethyl methacrylate, 2-hydroxypropyl methacrylate, 2-ethoxyethyl methacrylate, 1,1,1-trimethylolpropane trimethacrylate or

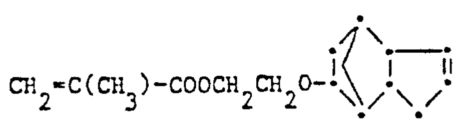

or mixtures of the said compounds.

11. A process according to claim 1, wherein a liquid composition which additionally contains a doubly-functional substance, especially a reaction product formed from a diglycidyl ether of bisphenol A, tetrabrombisphenol A or bisphenol F or from tetraglycidylated 4,4'-diaminodiphenylmethane and a less than equivalent amount of acrylic acid or methacrylic acid, is used.

12. A process according to claim 1, wherein diprimary alkylenediamines which have 2-14 C atoms and which can be interrupted in the chain by NH or O atoms, or amines of the formulae I to V

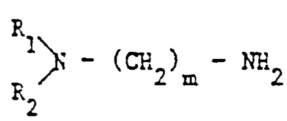

(I)

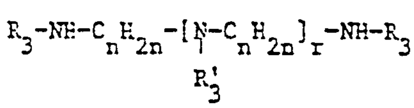

(II)

(Continued)

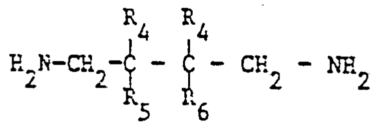 (III)

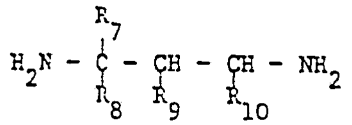 (IV)

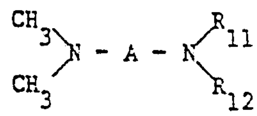 (V)

in which

m is an integer from 2 to 6, especially 2 or 3,

n is an integer from 2 to 12, especially 3 to 6,

r is zero, 1 or 2,

$R_1$ is hydrogen, $C_{1-4}$alkyl, especially methyl or ethyl,

$R_2$ is $C_{1-4}$alkyl, especially methyl or ethyl, cyclopentyl or cyclohexyl, the $R_3$s are each cyclopentyl, cyclohexyl, benzyl or phenylethyl,

$R_3'$ is the same as $R_3$ or is hydrogen, the

$R_4$s the (sic) independently of one another are hydrogen or methyl,

$R_5$ is phenyl, chlorophenyl or isopropylphenyl,

$R_6$ is phenyl, chlorophenyl or methoxyphenyl,

$R_7$ and $R_9$ independently of one another are hydrogen or $C_{1-4}$alkyl,

$R_8$ is phenyl or a 5-membered or 6-membered heterocyclic radical and

$R_{10}$ is hydrogen, $C_{1-4}$alkyl, phenyl or a 5-membered or 6-membered heterocyclic radical or

$R_7$ and $R_8$ and/or $R_9$ and $R_{10}$ together are $—(CH_2)_q—$ in which q is 4 or 5,

$R_{11}$ is $C_{1-12}$alkyl, especially $C_{1-8}$alkyl, $C_{6-8}$cycloalkyl, $C_{7-8}$aralkyl, $—A_1—CN$ or $—A_2—CH_2NH_2$ and

$R_{12}$ is hydrogen or $—A_2CH_2NH_2$ and A, $A_1$ and $A_2$ independently of one another are ethylene, 1,2-propylene or 1,3-propylene, are used as the heat-activatable curing agent c).

13. A process according to claim 1, wherein tetramethylenediamine, hexamethylenediamine, polyethylenediamine $H_2N—CH_2—CH_2(NH—CH_2CH_2)_b—NH_2$ in which b = 1-6, especially 1-4, 1,2-diaminocyclohexane, 1,3-bis-(aminomethyl)-cyclohexane, 1,4-bis-(aminomethyl)-cyclohexane, 4,4'-diaminodicyclohexylmethane, 1,3-xylylenediamine, 1,4-xylylenediamine, 1,3-diamino-1,3-diphenylpropane, 1,3-diamino-1-phenyl-3-(2-tetrahydrofuryl)-propane, N-ethylaminopiperazine, 3-aminomethyl-3,5,5-trimethylcyclohexylamine (isophoronediamine), N,N-dimethyl-1,3-diaminopropane, N,N-diethyl-1,3-diaminopropane, N,N-dimethyl-N'-(3-aminopropyl)-1,3-diaminopropane or N,N-dimethyl-N'-(2-cyanoethyl)-1,3-diaminopropane or mixtures thereof are used as the heat-activatable curing agent c).

14. A process according to claim 1, wherein isophoronediamine or mixtures of N,N-dimethyl-N'-(3-aminopropyl)-1,3-diaminopropane and N,N-dimethyl-N'-(2-cyanoethyl)-1,3-diaminopropane are used as the heat-activatable curing agent c).

15. A prepreg obtained by the process according to claim 1.

16. A process for the preparation of reinforced composite materials, which comprises hot-curing prepregs which have been prepared in accordance with claim 1.

**Revendications**

1. Procédé pour fabriquer des pré-imprégnés selon lequel on imprègne une matière de renforcement avec un mélange liquide, sans solvant, qui contient :

a) une résine époxydique,

b) un composé photopolymérisable,

c) un durcisseur thermo-activable pour la résine époxydique a), et éventuellement

d) un catalyseur de photopolymérisation pour le composé photopolymérisable b), et on expose à un rayonnement actinique jusqu'à ce que le mélange se soit transformé, par photopolymérisation du composé photopolymérisable, en une couche pratiquement solide tandis que la résine époxydique est restée dans une large mesure à l'état thermodurcissable, ce procédé étant caractérisé en ce qu'on utilise, comme durcisseur thermo-activable c), une amine aliphatique, cycloaliphatique ou araliphatique éventuellement substituée et on met en jeu le composé photopolymérisable b) dans un rapport tel, par

rapport à la composante a) thermodurcissable, que la matière, après l'exposition au rayonnement actinique, soit encore moulable à l'état thermoplastique.

2. Procédé selon la revendication 1, caractérisé en ce qu'on utilise la résine époxydique a) et le composé photopolymérisable b) en un rapport pondéral compris entre 100 : 3 et 100 : 30, plus particulièrement entre 100 : 6 et 100 : 20, ou en un rapport en équivalents compris entre 1 : 0,01 et 1 : 0,7, de préférence entre 1 : 0,08 et 1 : 0,3.

3. Procédé selon la revendication 1, caractérisé en ce qu'on utilise, comme matière de renforcement, des fibres de verre, de bore, d'acier inoxydable, de tungstène, de carbure de silicium, de carbone ou de polyamides aromatiques.

4. Procédé selon la revendication 1, caractérisé en ce qu'on utilise des fibres de verre comme matière de renforcement.

5. Procédé selon la revendication 1, caractérisé en ce qu'on utilise une résine époxydique qui contient des radicaux répondant à la formule A

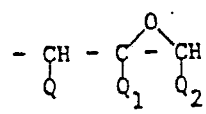

(A)

dans laquelle Q et $Q_2$ représentent chacun un atome d'hydrogène, auquel cas $Q_1$ représente un atome d'hydrogène ou un radical méthyle, ou Q et $Q_2$ forment ensemble un radical $—CH_2CH_2—$ ou $—CH_2CH_2CH_2—$, auquel cas $Q_1$ représente un atome d'hydrogène, fixés sur des atomes de carbone, d'oxygène, d'azote ou de soufre, et qui est dépourvue de radicaux acryloyles ou méthacryloyles.

6. Procédé selon la revendication 1, caractérisé en ce qu'on utilise, comme résines époxydiques a), des éthers diglycidyliques, éventuellement pré-allongés, de diphénols ou de diols aliphatiques contenant au plus 8 atomes de carbone, des éthers polyglycidyliques de novolaques, ou le diamino-4,4' diphénylméthane tétraglycidylé.

7. Procédé selon la revendication 1, caractérisé en ce qu'on utilise, comme résines époxydiques a), des éthers diglycidyliques, éventuellement pré-allongés, du bis-phénol A, du tétrabromo-bis-phénol A ou du bis-phénol F, le diamino-4,4' diphénylméthane tétraglycidylé, des éthers polyglycidyliques de novolaques dérivant du phénol et du formaldéhyde ou du crésol et du formaldéhyde, ou des mélanges de ces composés.

8. Procédé selon la revendication 1, caractérisé en ce qu'on utilise, comme composés photopolymérisables b), des esters acryliques contenant au moins un radical répondant à la formule B

$$CH_2{=}C(Q_3)COO— \qquad (B)$$

dans laquelle $Q_3$ représente un atome d'hydrogène, de chlore ou de brome ou un radical alkyle en $C_1$-$C_4$, en particulier un atome d'hydrogène ou un radical méthyle.

9. Procédé selon la revendication 1, caractérisé en ce qu'on utilise, comme composé photopolymérisable b), un ester acrylique répondant à l'une des formules D, E, F et G :

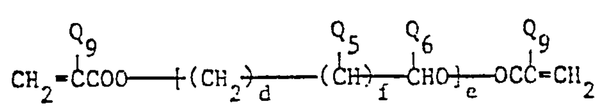

(D)

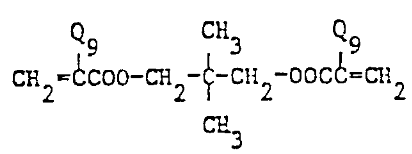

(E)

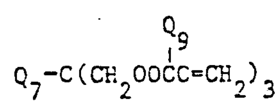

(F)

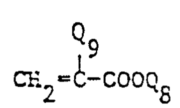

(G)

dans lesquelles :

d représente un nombre entier de 1 à 8,
e représente un nombre entier de 1 à 20,
f est égal à 0 ou à 1,
$Q_5$ représente $—H$, $—OH$ ou $—OOCC(Q_9){=}CH_2$,

$Q_6$ représente —H, un méthyle, un éthyle, —$CH_2OH$ ou —$CH_2OOC(Q_9)=CH_2$,

$Q_7$ représente un méthyle, un éthyle, —$CH_2OOCC(Q_9)=CH_2$ ou —$CH_2$—OH,

$Q_8$ représente un alkyle en $C_1$-$C_{18}$, en particulier en $C_1$-$C_8$, un hydroxyalkyle en $C_1$-$C_6$, un alcoxy-alkyle contenant au total de 2 à 8 atomes de carbone, en particulier de 3 à 6, un radical

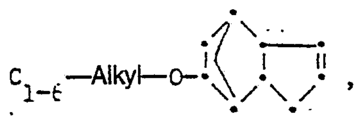 , un radical 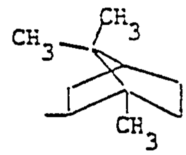

un radical N,N-dialkylamino-alkyle contenant au total de 3 à 12 atomes de carbone, en particulier de 3 à 6,

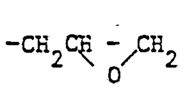 , 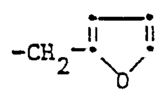 , 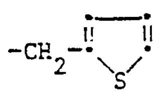

un alcényle en $C_3$ ou $C_4$, un cyclopentyle ou un cyclohexyle et $Q_9$ représente l'hydrogène ou un méthyle.

10. Procédé selon la revendication 1, caractérisé en ce qu'on utilise, comme composé photopolymérisable b), le bis-méthacrylate de l'éthylène-glycol, le bis-méthacrylate du butane-diol-1,4, le méthacrylate d'hydroxy-2 éthyle, le méthacrylate d'hydroxy-2 propyle, le méthacrylate d'hydroxy-2 éthyle, le tris-méthacrylate du triméthylol-1,1,1 propane, le composé de formule

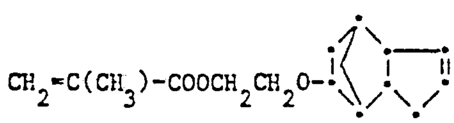

ou des mélanges des composés cités.

11. Procédé selon la revendication 1, caractérisé en ce qu'on utilise un mélange liquide contenant, en plus, une substance bifonctionnelle, en particulier un produit résultant de la réaction d'un éther diglycidylique du bis-phénol A, du tétrabromo-bis-phénol A ou du bis-phénol F, ou du diamino-4,4' diphénylméthane tétraglycidylé, avec une quantité insuffisante d'acide acrylique ou d'acide méthacrylique.

12. Procédé selon la revendication 1, caractérisé en ce qu'on utilise, comme durcisseurs thermo-activables c), des alkylène-diamines primaires qui contiennent de 2 à 14 atomes de carbone et dont la chaîne peut être interrompue par —NH— ou —O—, ou des amines répondant à l'une des formules I à V

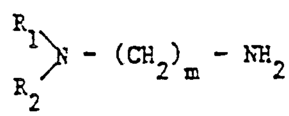 (I)

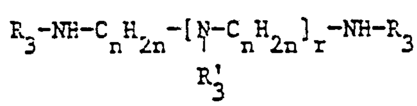 (II)

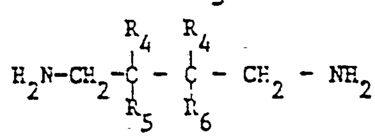 (III)

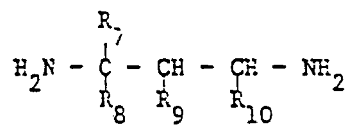 (IV)

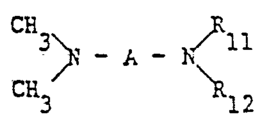 (V)

dans lesquelles :

m représente un nombre entier de 2 à 6, en particulier le nombre 2 ou le nombre 3,

n représente un nombre entier de 2 à 12, en particulier de 3 à 6,

r est égal à 0, à 1 ou à 2,

$R_1$ représente l'hydrogène ou un alkyle en $C_1$-$C_4$, en particulier un méthyle ou un éthyle,

$R_2$ représente un alkyle en $C_1$-$C_4$, en particulier un méthyle ou un éthyle, un cyclopentyle ou un cyclohexyle,

les $R_3$ représentent chacun un cyclopentyle, un cyclohexyle, un benzyle ou un phényléthyle,

$R_3'$ a la signification de $R_3$ ou représente l'hydrogène,

les $R_4$ représentent chacun, indépendamment l'un de l'autre, l'hydrogène ou un méthyle,

$R_5$ représente un phényle, un chlorophényle ou un isopropylphényle,

$R_6$ représente un phényle, un chlorophényle ou un méthoxyphényle,

$R_7$ et $R_9$ représentent chacun, indépendamment l'un de l'autre, l'hydrogène ou un alkyle en $C_1$-$C_4$,

$R_8$ représente un phényle ou un radical hétérocyclique à 5 ou 6 maillons et

$R_{10}$ représente l'hydrogène, un alkyle en $C_1$-$C_4$, un phényle ou un radical hétérocyclique à 5 ou 6 maillons, ou

$R_7$ et $R_8$, et/ou $R_9$ et $R_{10}$, forment ensemble un radical $—(CH_2)_q—$ dans lequel q est égal à 4 ou à 5,

$R_{11}$ représente un alkyle en $C_1$-$C_{12}$, en particulier un alkyle en $C_1$-$C_8$, un cycloalkyle en $C_6$-$C_8$, un aralkyle en $C_7$ ou $C_8$, un radical $—A_1—CN$ ou un radical $—A_2—CH_2NH_2$, et

$R_{12}$ représente l'hydrogène ou un radical $—A_2—CH_2NH_2$, les symboles A, $A_1$ et $A_2$ représentant chacun, indépendamment les uns des autres, un radical éthylène, propylène-1,2 ou propylène-1,3.

13. Procédé selon la revendication 1, caractérisé en ce qu'on utilise, comme durcisseur thermo-activable c), la tétraméthylène-diamine, l'hexaméthylène-diamine, des polyéthylène-diamines $H_2N—CH_2CH_2(NH—CH_2CH_2)_b—NH_2$ dans lesquelles b désigne un nombre de 1 à 6, plus particulièrement de 1 à 4, le diamino-1,2 cyclohexane, le bis-(aminométhyl)-1,3 ou -1,4 cyclohexane, le diamino-4,4' dicyclohexylméthane, la xylylène-diamine-1,3 ou -1,4, le diamino-1,3 diphényl-1,3 propane, le diamino-1,3 phényl-1 (tétrahydrofuryl-2)-3 propane, la N-éthylamino-pipérazine, l'aminométhyl-3 triméthyl-3,5,5 cyclohexylamine (isophorone-diamine), le N,N-diméthyl diamino-1,3 propane, le N,N-diéthyl diamino-1,3 propane, le N,N-diméthyl-N'-(amino-3 propyl) diamino-1,3 propane, le N,N-diméthyl-N'-(cyano-2 éthyl) diamino-1,3 propane, ou des mélanges de ces composés.

14. Procédé selon la revendication 1, caractérisé en ce qu'on utilise, comme durcisseur thermo-activable c), l'isophorone-diamine ou des mélanges de N,N-diméthyl-N'-(amino-3 propyl) diamino-1,3 propane et de N,N-diméthyl-N'-(cyano-2 éthyl) diamino-1,3 propane.

15. Pré-imprégnés qui ont été obtenus par le procédé de la revendication 1.

16. Procédé pour fabriquer des matériaux composites renforcés, procédé caractérisé en ce qu'on durcit à chaud des pré-imprégnés qui ont été fabriqués selon la revendication 1.